# EUROPEAN PATENT SPECIFICATION

(11) **EP 3 894 534 B1**
(45) Date of publication and mention of the grant of the patent: **11.09.2024**
(21) Application number: 19828597.5
(22) Date of filing: 11.12.2019
(51) Int. Cl.: C11D 3/37, C11D 7/32, C11D 7/50, C11D 11/00

(54) **METHOD FOR CLEANING A SUBSTRATE AND METHOD FOR MANUFACTURING DEVICE**
VERFAHREN ZUR REINIGUNG EINES SUBSTRATS UND VERFAHREN ZUR HERSTELLUNG EINER VORRICHTUNG
PROCÉDÉ DE NETTOYAGE D'UN SUBSTRAT ET PROCÉDÉ DE FABRICATION D'UN DISPOSITIF

(30) Priority: 14.12.2018 JP 2018234065
(43) Date of publication of application: 20.10.2021
(73) Proprietor: Merck Patent GmbH, 64293 Darmstadt (DE)
(72) Inventor: KINUTA, Takafumi, Kakegawa-shi Shizuoka, 437--1412 (JP); NAGAHARA, Tatsuro, Kakegawa-shi Shizuoka, 437--1412 (JP); HORIBA, Yuko, Kakegawa-shi Shizuoka, 436--0056 (JP)
(74) Representative: Rippel, Hans Christoph
(86) International application number: PCT/EP2019/084567
(87) International publication number: WO 2020/120534

(56) References cited:
- WO-A1-2017/156304
- WO-A2-2011/145880
- KR-A- 20100 078 695
- KR-A- 20160 059 641
- KR-B1- 101 880 305
- US-A1- 2012 073 607
- US-A1- 2015 337 245
- US-A1- 2017 330 762

## Description

### BACKGROUND OF THE INVENTION

### TECHNICAL FIELD

The present invention relates to a method for cleaning a substrate using a substrate cleaning solution.

### BACKGROUND ART

Conventionally, in the process of manufacturing a substrate, debris may be generated, for example, by a lithography process or the like. Therefore, the substrate manufacturing process may include a cleaning step for removing particles on the substrate. In the cleaning step, there are methods such as a method for physically removing particles by supplying a cleaning solution such as deionized water (DIW) on the substrate and a method for chemically removing particles with chemicals. However, as patterns become finer and more complicated, they become more susceptible to physical or chemical damage.

In addition, as a substrate cleaning step, there is a method for forming a film on a substrate to remove particles.

Patent Document 1 studies a substrate cleaning composition in which polymer having a special partial structure that essentially contains fluorine is used for forming a film, in order to obtain an affinity to a stripping solution and a dissolution rate.

Patent Document 2 studies a substrate cleaning apparatus which completely dissolves and removes a film formed by solidifying or curing a processing liquid on a substrate with a remover.

Patent document 3 studies a substrate cleaning apparatus which removes a film (particle holding layer) from a substrate by dissolving in a remover a solvent which remains in a particle holding layer.

Patent documents 4 to 11 disclose different compositions comprising polymeric components, alkaline components and solvents.

### PRIOR ART DOCUMENTS

### PATENT DOCUMENTS

[Patent document 1] JP-A 2016-34006
[Patent document 2] JP-A 2014-197717
[Patent document 3] JP-A 2018-110220
[Patent document 4] KR 2016 0059641 A
[Patent document 5] KR 2010 0078695 A
[Patent document 6] KR 101 880 305 B1
[Patent document 7] WO 2011/145880 A2
[Patent document 8] US 2017/330762 A1
[Patent document 9] US 2015/337245 A1
[Patent document 10] WO 2017/156304 A1
[Patent document 11] US 2012/073607 A1.

### SUMMARY OF THE INVENTION

### PROBLEMS TO BE SOLVED BY THE INVENTION

The inventors considered that in the technology of forming a film on a substrate to remove particles, one or more problems still need to be improved. They include, for example, the followings: removal of particles is insufficient; films are not formed uniformly and particles remain; films formed do not peel off from the substrate; films formed are not removed sufficiently and they become solid waste; when it is attempted to use a material having fluorine or the like, the synthesis becomes complicated; there is no portion in the film which becomes a trigger that the formed film peels; the held particles are detached and reattached on the substrate due to complete dissolution of a film; process control is required to leave the organic solvent in the film; and the substrate is damaged by using alkaline solution such as ammonia to remove or peel off the film.

The present invention has been made based on the technical background as described above and provides a method for cleaning a substrate using a substrate cleaning solution.

### MEANS FOR SOLVING THE PROBLEMS

The present invention provides a method for cleaning a substrate comprising (1) dripping a substrate cleaning solution on a substrate; (2) removing a solvent (C) in the substrate cleaning solution, and a polymer (A) forms a film; (3) making the film to hold particles on the substrate; and (4) applying a remover (F) on the substrate to remove the film in which the particles are held, the substrate cleaning solution comprising a polymer (A), an alkaline component (B), and a solvent (C), provided that the alkaline component (B) does not comprise ammonia, wherein the alkaline component (B) is represented by at least one of the formulae (B-1), (B-2), and (B-3): 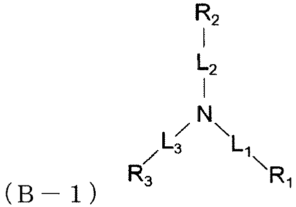 wherein L₁ is -CH₂-, -CH₂-CH₂-, -CH₂-CH₂-CH₂-, or the formula (B-1)': 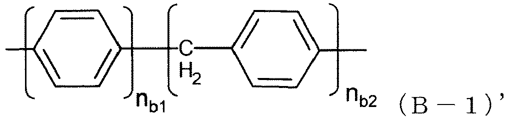 where n_{b1} is 0 or 1, n_{b2} is 0 or 1, and n_{b1} + n_{b2} is not equal to 0,
R₁ is -OH, -NH₂, or -N(CH₃)₂,
L₂ is a single bond, -CH₂-, -CH₂-CH₂-, -CH₂-CH₂-CH₂-, or the above formula (B-1)',
R₂ is -H, -OH, -NH₂, or -N(CH₃)₂,
L₃ is a single bond, -CH₂-, -CH₂-CH₂-, -CH₂-CH₂-CH₂-, or above formula (B-1)', and
R₃ is -H, -OH, -NH₂, or -N(CH₃)₂; 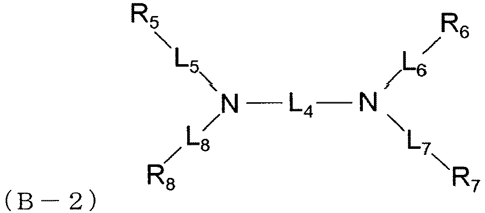
wherein,
L₄ is -CH₂-, -CH₂-CH₂-, or the above formula (B-1)',
L₅, L₆, L₇, and L₈ are each independently -CH₂- or -CH₂-CH₂-,
R₅, R₆, R₇, and R₈ are each independently -OH or -CH₃; and (B-3) 1,4-diazabicyclo[2.2.2]octane, hexamethylenetetramine or a nitrogen-containing saturated hydrocarbon ring, comprising -NH-CH₂-CH₂- as a structural unit.

The substrate cleaning solution used according to the present invention may further comprise a crack accelerating component (D).

In one embodiment of the present invention, the substrate cleaning solution is dripped on a substrate and dried to remove the solvent (C), and the polymer (A) forms a film. Preferably, the alkaline component (B) and /or the crack accelerating component (D) remain in the film on the substrate, and are not removed together with the solvent (C).

In the present invention, the film obtained by the substrate cleaning solution is removed by a remover (F). Preferably, the remover (F) is neutral or mildly acidic.

The present invention provides a device manufacturing method, comprising cleaning a substrate by the method of the invention, and further processing the su bstrate.

### EFFECTS OF THE INVENTION

Using the substrate cleaning solution in the method of the present invention, it is possible to desire one or more of the following effects. It is possible to sufficiently remove particles; it is possible to form a film uniformly and to reduce the remaining amount of particles; it is possible to sufficiently peel off the formed film from the substrate and to remove it; there is no need to use materials having fluorine or the like, whose synthesis is complicated; since there is a portion, which becomes a trigger that the film peels, in the film, it is possible to sufficiently remove the film; since there is no need to dissolve most of the film to remove, it is possible to prevent the detachment of the held particles; it is possible to make unnecessary the process control for leaving the organic solvent in the film; and since there is no need to use alkaline solution such as ammonia to remove or peel off the film, it is possible to prevent the substrate damaged.

### BRIEF DESCRIPTION OF THE DRAWINGS

Figure 1 is a cross section that schematically illustrates the appearance of a substrate surface in the substrate cleaning according to the present invention.
Figure 2 is a cross section that schematically illustrates the appearance of a substrate surface in the substrate cleaning according to the present invention.

### DETAILED DESCRIPTION OF THE INVENTION

### MODE FOR CARRYING OUT THE INVENTION

The above summary and the following details are intended to explain the present invention and not to limit the claimed invention.

In the present specification, unless otherwise specifically mentioned, the singular includes the plural and "one" or "that" means "at least one". In the present specification, unless otherwise specifically mentioned, an element of a concept can be expressed by a plurality of species, and when the amount (for example, mass % or mol%) is described, it means sum of the plurality of species.

"And/or" includes a combination of all elements and also includes single use of the element.

In the present specification, when a numerical range is indicated using "to" or "-", unless otherwise specifically mentioned, it includes both endpoints and units thereof are common. For example, 5 to 25 mol% means 5 mol% or more and 25 mol% or less.

In the present specification, the descriptions such as "C_{x-y}", "Cₓ-C_{y}" and "Cₓ" mean the number of carbons in a molecule or substituent. For example, C₁₋₆ alkyl means an alkyl chain having 1 or more and 6 or less carbons (methyl, ethyl, propyl, butyl, pentyl, hexyl etc.).

In the present specification, when polymer has a plural types of repeating units, these repeating units copolymerize. Unless otherwise specifically mentioned, these copolymerization may be any of alternating copolymerization, random copolymerization, block copolymerization, graft copolymerization, or a mixture thereof. When polymer or resin is represented by a structural formula, n, m or the like that is attached next to parentheses indicate the number of repetitions.

In the present specification, unless otherwise specifically mentioned, Celsius is used as the temperature unit. For example, 20 degrees means 20 degrees Celsius.

### <Substrate cleaning solution>

The substrate cleaning solution used according to the present invention comprises a polymer (A), an alkaline component (B), and a solvent (C), provided that the alkaline component (B) does not comprise ammonia, wherein the alkaline component (B) is represented by at least one of the formulae (B-1), (B-2), and (B-3).

As a preferred embodiment, the substrate cleaning solution is dripped on a substrate and dried to remove the solvent (C), and the polymer (A) forms a film. As a preferred embodiment, the alkaline component (B) and /or a below-mentioned crack accelerating component (D) remain in the film, and are not removed together with the solvent (C). One embodiment of "film formation" is "solidification". Furthermore, it is enough that the film obtained from the substrate cleaning solution has a hardness to the extent to hold particles, and the solvent (C) is not required to be completely removed (for example, through vaporization). The substrate cleaning solution becomes a film while gradually shrinking as the solvent (C) vaporizes. As for the "not removed with the solvent", it is accepted that an extremely small amount is removed (for example, vaporization, volatilization) in comparison with the whole. For example, it is accepted that 0 - 10 mass % (preferably 0 - 5 mass %, more preferably 0 - 3 mass %, further preferably 0 - 1 mass %, and still more preferably 0 - 0.5 mass %) relative to the original amount is removed.

Although this is not intended to limit the scope of the invention and not to be bound by theory, it is considered that the film holds particles on the substrate and is removed by being peeled off by a remover (F) that is described later. When the alkaline component (B) remains in the film, it is considered that the alkaline component (B) dissolves in the remover (F) and pH of the remover (F) is raised during peeling off the film by the remover (F). Thus, the remover (F) is no need to be alkaline solution such as ammnonia. When the alkaline component (B) and/or the crack accelerating component (D) remains in the film, it is considered that a portion which becomes a trigger that the film peels is generated.

### <Polymer>

The substrate cleaning solution used according to the present invention comprises a polymer (A).

The polymer (A) preferably comprises at least one of novolak, polyhydroxy styrene, polystyrene, polyacrylate derivatives, polymaleic acid derivatives, polycarbonate, polyvinyl alcohol derivatives, polymethacrylate derivatives, and copolymer of any combination of any of these. Preferably, the polymer (A) comprises at least one of novolak, polyhydroxystyrene, polyacrylic acid derivatives, polycarbonate, polymethacrylic acid derivatives, and copolymer of any combination of any of these. More preferably, the polymer (A) comprises at least one of novolak, polyhydroxystyrene, polycarbonate, and copolymer of any combination of any of these. Novolac may be phenol novolac.

It is described for clarity that the substrate cleaning solution used according to the present invention may comprise one or more of the above-mentioned preferred examples in combination as the polymer (A). For example, the polymer (A) may contain both novolak and polyhydroxystyrene.

It is a preferable embodiment of the present invention that the polymer (A) is dried to form a film, and the film is peeled off while holding particles without being mostly dissolved by the below-mentioned remover (F), which can contain the dissolved alkaline component (B). In addition, the embodiment in which a very few portions of the polymer (A) is dissolved by the remover (F) is accepted.

Preferably, the polymer (A) does not contain fluorine and/or silicon, and more preferably, it contains neither of them.

The above-mentioned copolymerization is preferably random copolymerization or block copolymerization.

Although it is not intended to limit the present invention, exemplified examples of the polymer (A) include the followings:

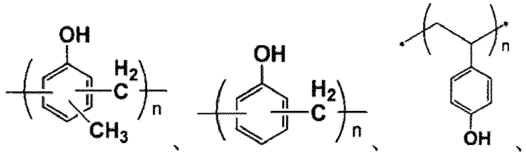

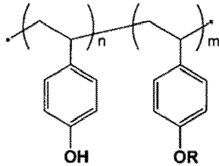

R represents a substituent such as a C₁₋₄ alkyl.

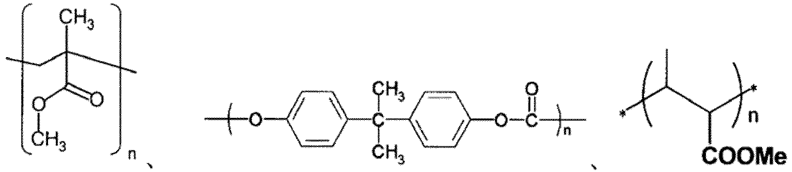

The weight-average molecular weight (M_{w}) of the polymer (A) is 150 - 500,000, more preferably 300 - 300,000, further preferably 500 - 100,000, and still more preferably 1,000 - 50,000.

The polymer (A) can be obtained through synthesis thereof. It is also possible to purchase it. When purchasing, examples of the supplier are indicated below. It is also possible that the supplier synthesizes the polymer (A) so as to make the effects of the present invention be exhibited.
novolak: Showa Kasei Kogyo Co., Ltd., Asahi Yukizai Corporation, Gunei Chemical Industry Co., Ltd., Sumitomo Bakelite Co., Ltd.
polyhydroxystyrene: Nippon Soda Co., Ltd., Maruzen Petrochemical Co., Ltd., Toho Chemical Industry Co., Ltd.
polyacrylic acid derivatives: Nippon Shokubai Co., Ltd.
polycarbonate: Sigma-Aldrich
polymethacrylic acid derivatives: Sigma-Aldrich

In one embodiment of the present invention, compared with the total mass of the substrate cleaning solution, the content of the polymer (A) is 0.1 - 50 mass %, preferably 0.5 - 30 mass %, more preferably 1 - 20 mass %, and further preferably 1 - 10 mass %. That is, it is one embodiment of the present invention that when the total mass of the substrate cleaning solution is made 100 mass %, the polymer (A) is 0.1 - 50 mass % based on this. That is, "compared with" can be reworded into "based on". Unless otherwise stated, the same is in the present specification.

### <Alkaline component>

The substrate cleaning solution used according to the present invention comprises an alkaline component (B). As a preferred embodiment, the alkaline component (B) remains in a film that has been formed from the substrate cleaning solution, and the alkaline component (B) dissolves in the remover (F) when the remover (F) peels off the film. For that, the boiling point of the alkaline component (B) at one atmospheric pressure is preferably 20 - 400°C, more preferably 115 - 350°C, and further preferably 200 - 350°C.

The alkaline component (B) is represented by at least one of the formulae (B-1), (B-2), and (B-3).

(B-1) is represented by the following formula: 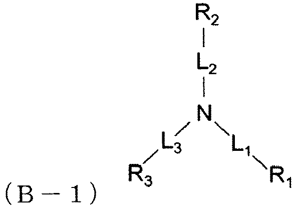 wherein,
L₁ is -CH₂-, -CH₂-CH₂-, -CH₂-CH₂-CH₂-, or the following formula (B-1)', preferably -CH₂-CH₂- or the following formula (B-1)', and more preferably -CH₂-CH₂-, 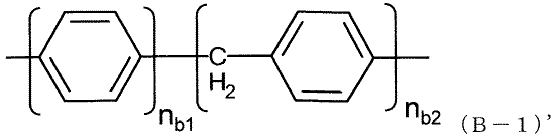
where n_{b1} is 0 or 1, n_{b2} is 0 or 1, and n_{b1} + n_{b2} is not equal to 0,
R₁ is -OH, -NH₂, or -N(CH₃)₂,
L₂ is a single bond, -CH₂-, -CH₂-CH₂-, -CH₂-CH₂-CH₂-, or the above formula (B-1)', preferably -CH₂-CH₂- or the above formula (B-1)', and more preferably -CH₂-CH₂-,
R₂ is -H, -OH, -NH₂, or -N(CH₃)₂,
L₃ is a single bond, -CH₂-, -CH₂-CH₂-, -CH₂-CH₂-CH₂-, or above formula (B-1)', preferably -CH₂-CH₂- or the above formula (B-1)', and
R₃ is -H, -OH, -NH₂, or -N(CH₃)₂.

Although there is no intention to limit the present invention, preferred examples of (B-1) include N-benzylethanolamine, diethanolamine, monoethanolamine, 2-(2-aminoethylamino)ethanol, 4,4'-diaminodiphenylmethane, 2-(butylamino)ethanol, 2-anilinoethanol, triethanolamine, ethylenediamine, diethylenetriamine, tris(2-aminoethyl)amine, and tris[2-(dimethylamino)ethyl]amine.

(B-2) is represented by the following formula. 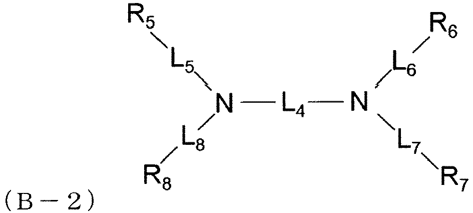 wherein
L₄ is -CH₂-, -CH₂-CH₂-, or the above formula (B-1)', preferably -CH₂- or -CH₂-CH₂-,
L₅, L₆, L₇, and L₈ are each independently -CH₂- or -CH₂-CH₂-,
R₅, R₆, R₇, and R₈ are each independently -OH or -CH₃.

Although there is no intention to limit the present invention, preferred examples of (B-2) include N,N,N',N'-tetrakis(2-hydroxyethyl)ethylenediamine and N,N,N',N'-tetraethylethylenediamine.

(B-3) is 1,4-diazabicyclo[2.2.2]octane, hexamethylenetetramine or a nitrogen-containing saturated hydrocarbon ring, comprising -NH-CH₂-CH₂- as a structural unit. As a preferred embodiment, the nitrogen- containing saturated hydrocarbon ring (B-3) has a ring structure by having repeatedly one type of structural unit. The nitrogen- containing saturated hydrocarbon ring (B-3) may be a cage-type three-dimensional structure or a planar ring structure.

Although there is no intention to limit the present invention, preferred examples of (B-3) having a planar ring structure include 1,4,7,10-tetraazacyclododecane, and 1,4,7,10,13,16-hexaazacycloalkyloctadecane.

It is described for clarity that the substrate cleaning solution used according to the present invention may comprise one or more of the above-described preferred examples in combination as the alkaline component (B). For example, the alkaline component (B) may comprise both N-benzylethanolamine and diethanolamine. Also, the alkaline component (B) may comprise both N,N,N',N'-tetrakis(2-hydroxyethyl)ethylenediamine and 1,4-diaza bicyclo [2.2.2] octane.

The molecular weight of the alkaline component (B) is preferably 50 - 500, and more preferably 80 - 300.

The alkaline component (B) can be obtained even by either synthesizing or purchasing. As a supplier, Sigma-Aldrich and Tokyo Chemical Industry Co., Ltd. are mentioned.

In one embodiment of the present invention, the content of the alkaline component (B) is preferably 1 - 100 mass %, more preferably 1 - 50 mass %, and further preferably 1 - 30 mass %, based on the total mass of the polymer (A) in the substrate cleaning solution.

### <Solvent>

The substrate cleaning solution used according to the present invention comprises a solvent (C). Preferably, the solvent (C) comprises an organic solvent. As one embodiment of the present invention, the solvent (C) has volatility. Having volatility means to have higher volatility compared with water. For example, the boiling point of the solvent (C) at one atmospheric pressure is preferably 50 - 200°C, more preferably 60 - 170°C, further preferably 70 - 150°C. It is also accepted that the solvent (C) contains a small amount of pure water. The content of the pure water contained in the solvent (C) is preferably 30 mass % or less, more preferably 20 mass % or less, and further preferably 10 mass % or less, and still more preferably 5 mass %, based on the total mass of the solvent (C). Containing no pure water (0 mass %) is also a preferred embodiment of the present invention. In the present specification, pure water is preferably DIW.

As a preferred embodiment of the present invention, components (including additives) comprised in the substrate cleaning solution are soluble in the solvent (C). The substrate cleaning solution in this embodiment is considered to have good embedding properties or film uniformity.

The organic solvents include alcohols such as isopropanol (IPA); ethylene glycol monoalkyl ethers such as ethylene glycol monomethyl ether and ethylene glycol monoethyl ether; ethylene glycol mono alkyl ether acetates such as ethylene glycol monomethyl ether acetate and ethylene glycol monoethyl ether acetate; propylene glycol monoalkyl ethers such as propylene glycol monomethyl ether (PGME), propylene glycol monoethyl ether (PGEE); propylene glycol monoalkyl ether acetates such as propylene glycol monomethyl ether acetate (PGMEA) and propylene glycol monoethyl ether acetate; lactic acid esters such as methyl lactate and ethyl lactate (EL); aromatic hydrocarbons such as toluene and xylene; ketones such as methyl ethyl ketone, 2-heptanone and cyclohexanone; amides such as N,N-dimethylacetamide and N-methyl pyrrolidone; and lactones such as γ-butyrolactone. These organic solvents can be used alone or in any combination of any two or more of these.

As a preferred embodiment, the organic solvent contained in the solvent (C) is selected from IPA, PGME, PGEE, EL, PGMEA, and any combination of any of these. When the organic solvent is a combination of two, the volume ratio is preferably 20:80 - 80:20, and more preferably 30:70 - 70:30.

In one embodiment of the present invention, the content of the solvent (C) is 0.1 - 99.9 mass %, preferably 50 - 99.9 mass %, more preferably 75 - 99.5 mass %, further preferably 80 - 99 mass %, and still more preferably 85 - 99 mass %, based on the total mass of the substrate cleaning solution.

### <Crack accelerating component>

In one embodiment of the present invention, the substrate cleaning solution further comprises a crack accelerating component (D). The crack accelerating component (D) comprises hydrocarbon and further comprises a hydroxy group (-OH) and/or a carbonyl group (-C(=O)-). When the crack accelerating component (D) is polymer, one kind of the structural unit comprises hydrocarbon in each unit and further has a hydroxy group and/or a carbonyl group. The carbonyl group includes carboxylic acid (-COOH), aldehyde, ketone, ester, amide and enone, and carboxylic acid is preferred.

Although this is not intended to limit the scope of the invention and not to be bound by theory, it is considered that when the substrate cleaning solution is dried to form a film on the substrate and the crack accelerating component (D) remains in the film, the soluble solute (B) generates a portion to become a trigger that the film peels during peeling of the film by the remover (F). For this purpose, it is preferable that the crack accelerating component (B) has a higher solubility in the remover (F) than the polymer (A). As an embodiment in which the crack accelerating component (D) contains ketone as carbonyl group, a cyclic hydrocarbon is mentioned. Exemplified examples thereof include 1,2-cyclohexanedione and 1,3-cyclohexanedione.

In a more particular embodiment, the crack accelerating component (D) is represented by at least one of the formulae (D-1), (D-2), and (D-3):
(D-1) is a compound comprising 1 to 6 (preferably 1 to 4) structural units, wherein the structural unit is represented by the formula (D-1)' and each structural unit is bonded via a linker L₉, 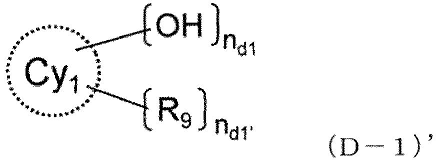 wherein,
L₉ is selected from at least one of a single bond and C₁₋₆ alkylene. The C₁₋₆ alkylene links structural units as a linker and is not limited to a divalent group. Preferably, it is divalent to tetravalent. The C₁₋₆ alkylene may be either of linear or branched. L₉ is preferably a single bond, methylene, ethylene or propylene.
Cy₁ is a C₅₋₃₀ hydrocarbon ring, preferably phenyl, cyclohexane or naphthyl, and more preferably phenyl. As a preferred embodiment, the linker L₉ links a plurality of Cy₁.
R₉ is each independently C₁₋₅ alkyl, preferably methyl, ethyl, propyl or butyl. The C₁₋₅ alkyl may be either of linear or branched.
n_{d1} is 1, 2, or 3, preferably 1 or 2, and more preferably 1.
n_{d1'} is 0, 1, 2, 3, or 4, preferably 0, 1 or 2.

Although there is no intention to limit the present invention, preferred examples of (D-1) include 2,2-bis(4-hydroxyphenyl)propane, 2,2'-methylenebis (4-methylphenol), 2,6-bis[(2-hydroxy-5-methylphenyl) methyl]-4-methylphenol, 1,3-cyclohexanediol, 4,4'-dihydroxybiphenyl, 2,6-naphthalenediol, 2,5-di-tert-butyl hydroquinone and 1,1,2,2-tetrakis(4-hydroxyphenyl)ethane. These may be obtained by polymerization or condensation.

2,6-bis[(2-hyd roxy-5-methylphenyl)methyl]-4-methylphenol is given as an example for explanation. In (D-1), the compound has three structural units (D-1)', and the structural units are linked by L₉ (methylene). n_{d1} = n_{d1'} = 1, and R₉ is methyl.

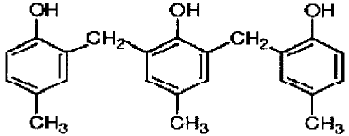

(D-2) is represented by the following formula. 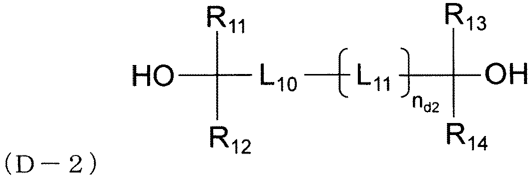 wherein,
R₁₁, R₁₂, R₁₃, and R₁₄ are each independently hydrogen or a C₁₋₅ alkyl, preferably hydrogen, methyl, ethyl, t-butyl or isopropyl, more preferably hydrogen, methyl or ethyl, and further preferably methyl or ethyl.
L₁₀ and L₁₁ are each independently a C₁₋₂₀ alkylene, a C₁₋₂₀ cycloalkylene, a C₂₋₄ alkenylene, a C₂₋₄ alkynylene or a C₆₋₂₀ arylene. These groups may be substituted by a C₁₋₅ alkyl or hydroxy. Here, alkenylene means a divalent hydrocarbon having one or more double bonds, and alkynylene means a divalent hydrocarbon group having one or more triple bonds. L₁₀ and L₁₁ are preferably a C₂₋₄ alkylene, acetylene (C₂ alkynylene) or phenylene, more preferably a C₂₋₄ alkylene or acetylene, and further preferably acetylene.
n_{d2} is 0, 1, or 2, preferably 0 or 1, and more preferably 0. Although there is no intention to limit the present invention, preferred examples of (D-2) include 3,6-dimethyl-4-octin-3,6-diol and 2,5-dimethyl-3-hexyne-2,5-diol. As another embodiment, preferable examples of (D-2) also include 3-hexyne-2,5-diol, 1,4-butynediol, 2,4-hexadiyne-1,6-diol, 1,4-butanediol, cis-1,4-dihydroxy-2-butene and 1,4-benzenedimethanol.

(D-3) is polymer comprising a structural unit represented by the formula (D-3)' and having the weight-average molecular weight (M_{w}) of 500 - 10,000. The M_{w} is preferably 600 - 5,000, and more preferably 700 - 3,000. 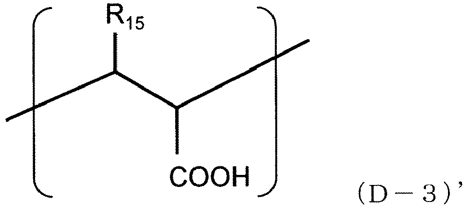 wherein,
R₁₅ is -H, -CH₃ or -COOH, preferably -H or -COOH. It is also accepted that one polymer (D-3) comprises two or more structural units each represented by (D-3)'.

Although there is no intention to limit the present invention, preferred examples of polymer (D-3) include polymer of acrylic acid, maleic acid, acrylic acid, or any combination of any of these. Polyacrylic acid, and copolymer of maleic acid and acrylic acid are further preferred examples.

In the case of copolymerization, it is preferably random copolymerization or block copolymerization, and more preferably random copolymerization.

Copolymer of maleic acid and acrylic acid is given as an example for explanation. The copolymer is contained in (D-3) and has two structural units (D-3)', and in one structural unit, R₁₅ is -H and in another structural unit, R₁₅ is -COOH.

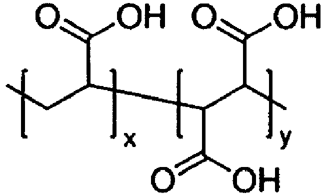

It is described for clarity that the substrate cleaning solution used according to the present invention may comprise one or more of the above-described preferred examples in combination as the crack accelerating component (D). For example, the crack accelerating component (D) may comprise both 2,2-bis(4-hydroxyphenyl)propane and 3,6-dimethyl-4-octin-3,6-diol.

In one embodiment of the present invention, the molecular weight of the crack accelerating component (D) is 80 - 10,000, preferably 90 - 5,000, and more preferably 100 - 3,000. When the crack accelerating component (D) is resin or polymer, the molecular weight represents weight-average molecular weight (M_{w}).

The crack accelerating component (D) can be obtained even by either synthesizing or purchasing. As a supplier, Sigma-Aldrich, Tokyo Chemical Industry Co., Ltd. and Nippon Shokubai Co., Ltd. are mentioned.

In one embodiment of the present invention, the content of the crack accelerating component (D) is preferably 1 - 100 mass %, more preferably 1 - 50 mass %, and further preferably 1 - 30 mass %, based on the total mass of the polymer (A) in the substrate cleaning solution.

### <Further additive>

The substrate cleaning solution used in the present invention may additionally comprise a further additive (E). In one embodiment of the present invention, the further additive (E) comprises a surfactant, an antibacterial agent, a germicide, an antiseptic, an antifungal agent, or a base (preferably, a surfactant), and it may comprise any combination of any of these.

In one embodiment of the present invention, the content of the further additive (E) (in the case of plural, the sum thereof) is 0 - 10 mass %, more preferably 0 - 5 mass %, further preferably 0 - 3 mass %, and still more preferably 0 - 1 mass %, based on the total mass of the polymer (A) in the substrate cleaning solution. Containing no further additive (0 mass %) is also a preferred embodiment of the present invention.

### <Remover>

In one embodiment of the present invention, as described above, the substrate cleaning solution is dripped on a substrate and dried to remove the solvent (C), and the polymer (A) forms a film. As a preferred embodiment, the alkaline component (B) and /or the crack accelerating component (D) remain in the film, and are not removed together with the solvent (C). The film is capable of holding particles present on the substrate, and the film is removed by the remover while holding.

The remover (F) is preferably neutral or mildly acidic. The pH of the remover (F) is preferably 4 - 7, more preferably 5 - 7, and still more preferably 6 - 7. The measurement of pH is preferably carried out after being degassed, to avoid the influence of the dissolution of carbon dioxide gas in the air.

Preferably, the remover (F) comprises pure water. As mentioned above, the substrate cleaning solution comprises the alkaline component (B) which dissolves in the remover (F) and thus pH of the remover (F) is raised. Accordingly, most of the initial remover (F) may be pure water. The ratio of pure water contained in the solvent (F) is preferably 80 - 100 mass %, more preferably 90 - 100 mass %, further preferably 95 - 100 mass %, and still more preferably 99 - 100 mass %, based on the total mass of the solvent (F). As a preferred embodiment, the remover (F) consists only of pure water (100 mass%).

Although this is not intended to limit the scope of the invention and not to be bound by theory, a state of cleaning the substrate according to the present invention is described using a schematic figure for the understanding of the present invention.

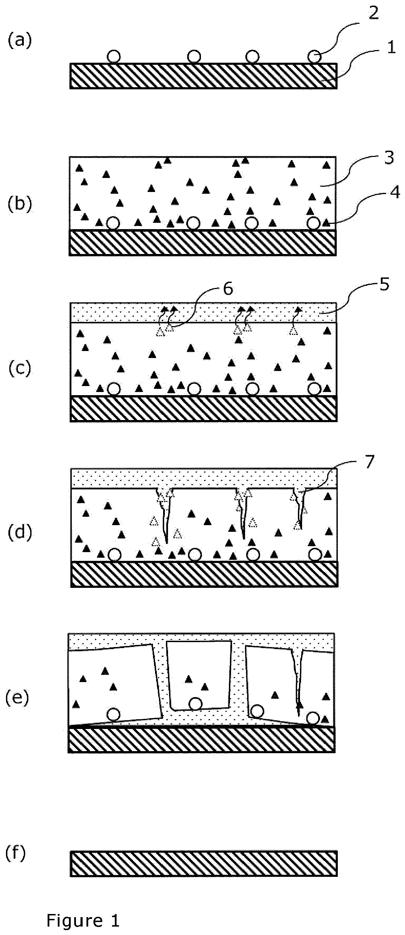

The substrate cleaning solution used in the embodiment of FIG. 1 is composed of a polymer (A), an alkaline component (B) and a solvent (C). (a) shows a state in which particles 2 are attached to the substrate 1. The substrate cleaning solution used in the present invention is dripped on this substrate and dried, and the state in which the polymer forms a film (b) is shown by (b). In (b), the film becomes a particle holding layer 3, and an alkaline component 4 remains in the film. Thereafter, a remover 5 is applied on the film, and the state in which the alkaline component has dissolved in the remover is shown by (c). Through such a dissolvement, traces 6 due to the elution of the alkaline component in the particle holding layer 3 are generated. It is considered that the pH of the remover in the vicinity of the film is raised by the elution of the alkaline component and the effect of peeling off the film from the substrate is enhanced. Further, the traces 6 become a trigger that the film peels. The state in which the cracks 7 grow from the traces 6 is shown by (d). The state in which the film parted by the growth of the cracks 7 is removed from the substrate while holding particles is shown by (e). The state of the substrate obtained by being cleaned is shown by (f).

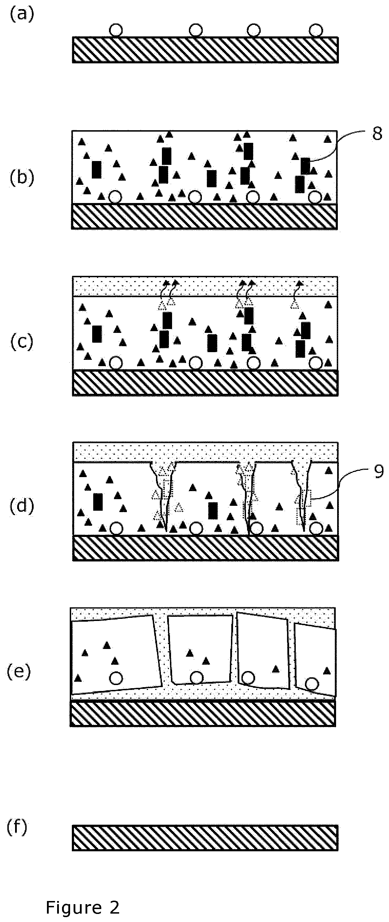

The substrate cleaning solution used in the embodiment of FIG. 2 is composed of a polymer (A), an alkaline component (B), a solvent (C), and a crack accelerating component (D). FIG. 2 is different from FIG. 1 in further comprising the crack accelerating component. The process in the substrate cleaning is proceeded as same as is the case in FIG. 1, except that a crack accelerating component 8 remains in the particle holding layer 3 in (b). Then, the crack accelerating component dissolves in the remover and traces 9 due to the elution of the crack accelerating component in the particle holding layer 3 are generated. The traces 9 enhance the action of peeling off the film from the substrate. The traces 9 itself can become a trigger that the film peels.

### <Cleaning of substrate>

The method of the present invention is used to clean a substrate. For the cleaning of a substrate, an apparatus (for example, described in JP-A 2018-110220) can be used. The present invention provides a method for manufacturing a cleaned substrate as one embodiment.

The method for cleaning a substrate is described below. In the following, numbers in parentheses indicate the order of steps. For example, when the steps (0-1), (0-2) and (1) are described, the order of the steps is as described above.

The substrate cleaning comprises:
(1) dripping the substrate cleaning solution used in the present invention on a substrate;
(2) removing the solvent (C) in the substrate cleaning solution, and the polymer (A) forms a film;
(3) making the film hold particles on the substrate; and
(4) applying a remover (F) on the substrate to remove the film in which particles are held.

The above (1) is preferably carried out by dripping the substrate cleaning solution nearly at the center of the horizontally postured substrate through a nozzle or the like in an apparatus suitable for substrate cleaning. The dripping may be in the form of liquid column or dropping. At the time of the dripping, the substrate is rotated, for example, at 10 to several tens of rpm, so that the generation of dripping traces can be suppressed.

The dripping amount is preferably 0.5 - 10 cc. These conditions can be adjusted so that the substrate cleaning solution is uniformly applied and spread.

The removal of the solvent (C) described in the above (2) is preferably carried out by drying, preferably by spin-drying. The spin-dry is carried out at 500 - 3,000 rpm (more preferably 500 - 1,500 rpm, and further preferably 500 - 1,000 rpm) for preferably 0.5 - 90 seconds (more preferably 5 - 80 seconds, further preferably 15 - 70 seconds, and still more preferably 30 - 60 seconds). Accordingly, the solvent (C) can be dried while spreading the substrate cleaning solution over the entire surface of the substrate. Preferably, the substrate is a disk shape substrate having a diameter of 200 - 600 nm (more preferably 200 - 400 mm).

Making the film hold particles on the substrate referred in the above (3) means it is carried out by removing the solvent (C) referred in the above (2), whereby the polymer (A) forms a film and holds particles. That is, it can be said also that the above steps (2) and (3) occur continuously by one operation. Here, the removal of the solvent (C) referred in the above (2) accepts a state in which the solvent (C) slightly remains in the film. In one embodiment of the present invention, 95% or more (preferably 98% or more, and more preferably 99% or more) of the solvent (C) is volatilized at the end of the above steps (2) and (3) and does not remain in the film.

As a preferred embodiment, solid components such as the alkaline component (B) and the crack accelerating component (D) remain in the film and not removed together with the solvent (C). Here, "remain in the film" means preferably to be in a state of coexistence in one film, but not to form separate layers.

The above steps (2) and/or (3) may be carried out while raising the temperature in the apparatus. It can be expected that raising of the temperature promotes the volatilization of the solvent (C) and the film formation of solid components such as the polymer (A). When the temperature is raised, it is preferably 40 - 150°C.

In the above (4), a remover (F) is applied on the substrate to remove the film in which particles are held (particle holding layer). The application can be performed by dripping, spraying or dipping. The dripping may be performed so as to form a liquid pool (paddle) on the substrate or may be dripped continuously. In one embodiment of the present invention, the remover (F) is dripped at the center of the substrate while the substrate is rotating at 500 - 800 rpm.

When the remover (F) removes (for example, peels off) the particle holding layer, it is considered that the alkaline component (B) and/or the crack accelerating component (D) remained in the film generates a portion to become a trigger that the film peels. Accordingly, it is preferable that the alkaline component (B) and/or the crack accelerating component (D) have a higher solubility in the remover (F) than the polymer (A). The solubility can be evaluated by known methods. For example, it can be determined under the condition of 20 - 35°C (more preferably 25±2°C) by providing a flask charged with 100 ppm of the above (A) or (B) in pure water, covering the flask with a cap, shaking for 3 hours in a shaker, and confirming whether (A) or (B) is dissolved or not. For evaluation of solubility, the pure water can be changed to alkaline solution such as 5.0 mass % ammonia water.

It is a preferable embodiment of the present invention that the particle holding layer is removed from the substrate while holding particles without being completely dissolved by the remover (F). The particle holding layer is considered to be removed by, for example, becoming in a state of being finely cut by the "portion to become a trigger that the film peels".

In the method for cleaning a substrate according to the present invention, an embodiment additionally including at least one steps other than the above is also preferable. Such processes include those known in the substrate cleaning. For example, the following steps may be mentioned.
(0-1) A step of processing the substrate by etching to form a pattern and removing an etching mask
   The substrate to be cleaned may be a processed substrate, and the processing may be performed by a lithography technique.
(0-2) A step of cleaning the substrate
   In order to reduce the number of particles on the substrate, the substrate may be cleaned with a known cleaning solution (such as a rinse solution). It is one of the objects of the present invention to remove a few particles that remain even by this.
(0-3) A step of prewetting the substrate
   It is also a preferred embodiment to prewet the substrate in order to improve the coatability of the substrate cleaning solution used in the present invention and spread it uniformly on the substrate. Preferably, the liquid used for prewetting (prewetting solution) includes IPA, PGME, PGMEA, PGEE, n-butanol (nBA), pure water, and any combination of any of these.
(0-4) A step of cleaning the substrate
   In order to replace the prewetting solution referred in the above (0-3), a step of cleaning the substrate is also a preferred embodiment. It is an embodiment of the present invention to make the step (0-4) unneeded by inserting the step (0-2).
(3-1) A step of applying a liquid on the particle holding layer
   It is also possible to include a step of applying a liquid different from the remover after the step (3) in order to enhance the hydrophilicity or hydrophobicity (preferably hydrophilicity) of the particle holding layer. It is preferable that the liquid has a weaker power to dissolve the solid component of the particle holding layer than the remover (F). The process (3-1) may be omitted.
(5) A step of dripping pure water or an organic solvent on the substrate after the removal of the film in which particles are held and removing pure water or the organic solvent to clean the substrate further
   It is also a preferred embodiment to further clean the substrate with pure water or an organic solvent (preferably an organic solvent) in order to remove local film residue and particles residue. The organic solvent includes IPA, PGME, PGMEA, PGEE, nBA, and any combination of at least two of these.
(6) A step of drying the substrate
   The means for drying the substrate include spin drying, supplying dry gas (such as spraying), reduced pressure, heating, and any combination of any of these.

### <Substrate>

The substrate to be cleaned in the present invention include semiconductor wafers, glass substrates for liquid crystal display, glass substrates for organic EL display, glass substrates for plasma display, substrates for optical disk, substrates for magnetic disk, substrates for magneto-optical disk, glass substrates for photomask, substrates for solar cell, and the like. The substrate may be a non-processed substrate (for example, a bare wafer) or a processed substrate (for example, a patterned substrate). The substrate may be composed by laminating a plurality of layers. Preferably, the surface of the substrate is a semiconductor. The semiconductor may be composed of oxide, nitride, metal, and any combination of any of these. Further, the surface of the substrate is preferably selected from the group consisting of Si, Ge, SiGe, Si₃N₄, TaN, SiO₂, TiOz, Al₂O₃, SiON, HfOz, T₂O₅, HfSiO₄, Y₂O₃, GaN, TiN, TaN, Si₃N₄, NbN, Cu, Ta, W, Hf, and Al.

### <Device>

By further processing the substrate manufactured by the cleaning method according to the present invention, a device can be manufactured. Examples of the device include semiconductors, liquid crystal display devices, organic EL display devices, plasma display devices, and solar cell devices. A known method can be used for processing these. After device formation, if desired, the substrate can be cut into chips, connected to lead frame, and packaged with resin. One example of this packaged product is a semiconductor.

The present invention is described below with reference to examples. In addition, the embodiment of the present invention is not limited only to these examples.

### Preparation of patterned substrate

A KrF resist composition (AZ DX-6270P, Merck Performance Materials K.K., hereinafter referred to as MPM) is dripped on an 8-inch Si substrate, and spin-coated on the substrate at 1500 rpm. The substrate is soft-baked at 120°C for 90 seconds. The resultant is exposed using KrF stepper (FPA-3000 EX5, Canon Inc.) with 20 mJ/cm², subjected to PEB (post exposure bake) for 90 seconds at 130°C and developed with a developer (AZ MIF-300, MPM). Thereby, a line-and-space resist pattern having a pitch of 360 nm and a duty ratio of 1 : 1 is obtained. The substrate is etched with a dry etching apparatus (NE-5000N, ULVAC Inc.) using the resist pattern as an etching mask. Thereafter, the substrate is cleaned with a stripper (AZ 400T, MPM), and the resist pattern and the resist residue are peeled off. Thereby, a patterned substrate having a pattern with a pitch of 360 nm, a duty ratio of 1 : 1, and a line height of 150 nm is produced.

### Preparation of bare substrate

An 8-inch Si substrate is used.

### Adjustment of evaluation substrate

Particles are attached to the patterned substrate and the bare substrate described above.

Ultra-high purity colloidal silica (PL-10H, Fuso Chemical Industry Co., Ltd., average primary particle size: 90 nm) is used as particles for experiment. 50 mL of the silica fine particle composition is dripped and applied by rotating at 500 rpm for 5 seconds. Thereafter, the solvent of the silica fine particle composition is spin-dried by rotating at 1000 rpm for 30 seconds. Thereby, an evaluation substrate is obtained.

### Comparative tests as for the existence or non-existence of each component in the substrate cleaning solution

5 g of Novolak (Mw: about 5,000, polymer (A)) is added to 95 g of isopropanol (solvent (C)). The resultant is stirred with a stirrer for 1 hour to obtain a solution containing polymer (A) in a concentration of 5 mass %. Each 2.5 g of diethanolamine (alkaline component (B)) and 3,6-dimethyl-4-octin-3,6-diol (Tokyo Chemical Industry Co., Ltd., hereinafter referred to TCI, crack accelerating component (D)) are added to the solution. The resultant is stirred with a stirrer for 1 hour. This solution is filtered with Optimizer UPE (Nippon Entegris K.K.). Thereby, a substrate cleaning solution comprising (A), (B), and (D) is obtained.

A substrate cleaning solution comprising (A) and (B) is obtained in the same manner except that the component (D) is not added.

A substrate cleaning solution comprising (A) and (D) is obtained in the same manner except that the component (B) is not added.

A substrate cleaning solution comprising (B) and (D) is obtained in the same manner except that the component (A) is not added.

Using Coater/Developer RF³ (SOKUDO Co., Ltd.), 10 cc of each substrate cleaning solution is dripped on each evaluation substrate, and coating and drying are performed by rotating at 1,500 rpm for 60 seconds. While rotating the substrate at 100 rpm, DIW is dripped for 10 seconds, the whole substrate is covered with DIW, and this state is maintained for 20 seconds. By rotating the substrate at 1,500 rpm, the film is dried. When the film exists, the film is peeled off and removed by the rotation.

The amounts of residual particles on these substrates are compared. A bright field defect inspection system (UVision 4, Applied Materials Inc.) is used for the evaluation of the patterned substrate, and a dark field defect inspection system (LS-9110, Hitachi High-Technologies Corporation) is used for the evaluation of the bare substrate.

The substrate cleaning solution comprising (A), (B), and (D) resulted in the fewest residual particles, and the substrate cleaning solution comprising (B) and (D) resulted in the most residual particles, on both patterned substrates and bare substrates. The substrate cleaning solution comprising (A) and (B) resulted in slightly more residual particles than the substrate cleaning solution comprising (A) and (D).

### Preparation Example 1 of Cleaning Solution 1

5 g of Novolak (Mw: about 5,000, polymer (A)) is added to 95 g of isopropanol (solvent (C)). The resultant is stirred with a stirrer for 1 hour to obtain a solution containing polymer (A) in a concentration of 5 mass %. Each 0.05 g of N-benzylethanolamine (TCI, alkaline component (B)) and 2,2-bis(4-hydroxyphenyl)propane (TCI, crack accelerating component (D)) are added to the solution. The resultant is stirred with a stirrer for 1 hour. This solution is filtered with Optimizer UPE (Nippon Entegris K.K.). Thereby, Cleaning Solution 1 is obtained. This is indicated in Table 1-1.

In the below Tables 1-1 and 1-2, above mentioned Novolak, N-benzylethanolamine, and isopropanol are abbreviated as A1, B1, and D1, respectively. The number in parentheses in column (A) means the concentration (mass %) of the polymer (A) when the polymer (A) is added to the solvent (C). The number in parentheses in column (B) means the concentration (mass %) of the alkaline component (B) compared with the polymer (A) when the alkali component (B) is added to the solution. The number in parentheses in column (C) means the concentration (mass %) of the crack accelerating component (C) compared with the polymer (A) when the crack accelerating component (C) is added to the solution.

### [Table 1-1]

**Table 1-1**

| | (A) | (B) | (D) | (C) solvent | Removal Evaluation | |
|---|---|---|---|---|---|---|
| | | | | | Patterned substrate | Bare substrate |
| Cleaning Solution 1 | A1 (5%) | B1 (1%) | D1 (1%) | IPA | A | A |
| Cleaning Solution 2 | A1 (5%) | B1 (10%) | D1 (1%) | IPA | AA | AA |
| Cleaning Solution 3 | A1 (5%) | B1 (50%) | D1 (1%) | IPA | AA | AA |
| Cleaning Solution 4 | A1 (5%) | B1 (100%) | D1 (1%) | IPA | A | AA |
| Cleaning Solution 5 | A1 (5%) | B1(1%) | D1 (10%) | IPA | AA | A |
| Cleaning Solution 6 | A1 (5%) | B1 (10%) | D1 (10%) | IPA | AA | AA |
| Cleaning Solution 7 | A1 (5%) | B1 (50%) | D1 (10%) | IPA | AA | AA |
| Cleaning Solution 8 | A1 (5%) | B1 (100%) | D1 (10%) | IPA | A | A |
| Cleaning Solution 9 | A1 (5%) | B1 (1%) | D1 (50%) | IPA | A | AA |
| Cleaning Solution 10 | A1 (5%) | B1 (10%) | D1 (50%) | IPA | A | AA |
| Cleaning Solution 11 | A1 (5%) | B1 (50%) | D1 (50%) | PGME | A | AA |
| Cleaning Solution 12 | A1 (5%) | B1 (100%) | D1 (50%) | PGME | A | A |
| Cleaning Solution 13 | A1 (5%) | B1 (1%) | D1 (100%) | PGME | A | AA |
| Cleaning Solution 14 | A1 (5%) | B1 (10%) | D1 (100%) | PGME | A | AA |
| Cleaning Solution 15 | A1 (5%) | B2 (50%) | D2(100%) | PGME | A | A |
| Cleaning Solution 16 | A1 (5%) | B2 (100%) | D2(100%) | PGME | A | A |
| Cleaning Solution 17 | A2(5%) | B2 (50%) | D2(50%) | PGME | AA | AA |
| Cleaning Solution 18 | A3(5%) | B2 (50%) | D2(50%) | PGME | AA | AA |
| Cleaning Solution 19 | A4(5%) | B2 (50%) | D2(50%) | PGME | AA | AA |
| Cleaning Solution 20 | A5(5%) | B2 (50%) | D2(50%) | PGME | AA | AA |
| Cleaning Solution 21 | A6(5%) | B2(50%) | D2(50%) | PGEE | AA | AA |
| Cleaning Solution 22 | A7(5%) | B2(50%) | D2(50%) | PGEE | AA | AA |
| Cleaning Solution 23 | A8(5%) | B2(50%) | D2(50%) | PGEE | AA | AA |
| Cleaning Solution 24 | A9(5%) | B2(50%) | D2(50%) | PGEE | AA | AA |
| Cleaning Solution 25 | A10(5%) | B2(50%) | D2(50%) | PGEE | A | AA |
| Cleaning Solution 26 | A11 (5%) | B2 (50%) | D2(50%) | PGEE | AA | AA |
| Cleaning Solution 27 | A12 (5%) | B2 (50%) | D2(50%) | PGEE | AA | AA |
| Cleaning Solution 28 | A13 (5%) | B2 (50%) | D2(50%) | PGEE | A | AA |

### [Table 1-2]

**Table 1-2**

| | (A) | (B) | (D) | (C) solvent | Removal Evaluation | |
|---|---|---|---|---|---|---|
| | | | | | Patterned substrate | Bare substrate |
| Cleaning Solution 29 | A14(1%) | B2 (50%) | D2(50%) | IPA:PGME=1:1 | A | AA |
| Cleaning Solution 30 | A15(1%) | B2 (50%) | D2(50%) | IPA:PGME=1:1 | A | AA |
| Cleaning Solution 31 | A16(1%) | B2 (50%) | D2(50%) | IPA:PGME=1:1 | A | AA |
| Cleaning Solution 32 | A17(1%) | B2 (50%) | D2(50%) | IPA:PGME=1:1 | AA | AA |
| Cleaning Solution 33 | A18(20%) | B2 (50%) | D2(50%) | IPA:PGEE=1:2 | AA | AA |
| Cleaning Solution 34 | A19(20%) | B2 (50%) | D2(50%) | IPA:PGEE=1:2 | A | AA |
| Cleaning Solution 35 | A1 (20%) | B2 (50%) | D3 (50%) | IPA:PGEE=1:2 | AA | AA |
| Cleaning Solution 36 | A1 (20%) | B2 (50%) | D4 (50%) | IPA:PGEE=1:2 | A | AA |
| Cleaning Solution 37 | A1 (20%) | B2 (50%) | D5(50%) | IPA:PGEE=1:2 | AA | AA |
| Cleaning Solution 38 | A1 (20%) | B2 (50%) | D6(50%) | IPA:PGEE=1:2 | A | AA |
| Cleaning Solution 39 | A1 (20%) | B2 (50%) | D7(50%) | IPA:PGEE=1:2 | A | A |
| Cleaning Solution 40 | A1 (20%) | B2 (50%) | D8(50%) | IPA:PGEE=1:2 | AA | AA |
| Cleaning Solution 41 | A20 (20%) | B2 (50%) | D9(50%) | IPA:PGEE=1:2 | A | A |
| Cleaning Solution 42 | A20 (20%) | B2(50%) | D10(50%) | IPA:PGEE=1:2 | AA | AA |
| Cleaning Solution 43 | A20(5%) | B2(50%) | D11 (50%) | EL | AA | AA |
| Cleaning Solution 44 | A20(5%) | B2(50%) | D12 (50%) | EL | AA | AA |
| Cleaning Solution 45 | A20(5%) | B2(50%) | D13 (50%) | EL | AA | AA |
| Cleaning Solution 46 | A20(5%) | B3 (50%) | D2(50%) | EL | AA | AA |
| Cleaning Solution 47 | A20(5%) | B4 (50%) | D2(50%) | EL | AA | AA |
| Cleaning Solution 48 | A20(5%) | B5 (50%) | D2(50%) | EL | AA | AA |
| Cleaning Solution 49 | A20(5%) | B6 (50%) | D2(50%) | EL | AA | AA |
| Cleaning Solution 50 | A20(5%) | B7 (50%) | D2(50%) | EL | AA | AA |
| Cleaning Solution 51 | A20(5%) | B8 (50%) | D2(50%) | EL | AA | AA |
| Cleaning Solution 52 | A1 (5%) | B1 (50%) | D2(50%) | PGMEA | A | A |
| Cleaning Solution 53 | A1 (5%) | B9 (50%) | D2(50%) | PGMEA | A | A |
| Cleaning Solution 54 | A1 (5%) | B10(50%) | D2(50%) | PGMEA | A | A |
| Cleaning Solution 55 | A1 (5%) | B11(50%) | D2(50%) | PGMEA | A | A |
| Cleaning Solution 56 | A1 (5%) | B12(50%) | D2(50%) | PGMEA | A | A |
| Cleaning Solution 57 | A1 (5%) | B13(50%) | D2(50%) | PGMEA | A | A |
| Cleaning Solution 58 | A1 (5%) | B14(50%) | D2(50%) | PGMEA | A | A |
| Cleaning Solution 59 | A1 (5%) | B15(50%) | D2(50%) | PGMEA | A | AA |
| Cleaning Solution 60 | A1 (5%) | B16(50%) | D2(50%) | PGMEA | A | A |
| Cleaning Solution 61 | A1 (5%) | B17(50%) | D2(50%) | PGMEA | A | A |
| Cleaning Solution 62 | A1 (5%) | B18(50%) | D2(50%) | PGMEA | A | AA |
| Comparative Cleaning Solution 1 | - | - | - | IPA | D | D |

In the Tables 1-1 and 1-2, the followings are abbreviated as follows:
novolak (Mw: about 1,000) : A2,
novolak (Mw: about 10,000) : A3,
novolak (Mw: about 100,000) : A4,
phenol novolak (Mw: about 1,000) : A5,
phenol novolak (Mw: about 10,000) : A6,
phenol novolak (Mw: about 100,000) : A7,
polyhydroxystyrene (Mw: about 1,000) : A8,
polyhydroxystyrene (Mw: about 10,000) : A9,
polyhydroxystyrene (Mw: about 100,000) : A10,
polyacrylic acid derivative having a structure shown below (Mw: about 1,000) : A11, 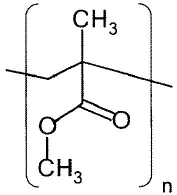
polyacrylic acid derivative having a structure shown above (Mw: about 10,000) : A12,
polyacrylic acid derivative having a structure shown above (Mw: about 100,000) : A13,
polycarbonate (Mw: about 1,000) : A14,
polycarbonate (Mw: about 10,000) : A15,
polycarbonate (Mw: about 100,000) : A16,
polymethylmethacrylate (Mw: about 1,000) : A17,
polymethylmethacrylate (Mw: about 10,000) : A18,
polymethylmethacrylate (Mw: about 100,000) : A19, polymethylmethacrylate (Mw: about 5,000) : A20,
diethanolamine : B2,
monoethanolamine : B3,
2-(2-amonoethylamino)ethanol : B4,
4,4'-diaminodiphenylmethane : B5,
1,4-diazabicyclo[2.2.2]octane : B6,
hexamethylenetetramine : B7,
2-(butylamino)ethanol : B8,
2-anilinoethanol : B9,
triethanolamine : B10,
N,N,N',N'-tetrakis(2-hydroxyethyl)ethylenediamine : B11,
ethylenediamine : B12,
diethylenetriamine : B13,
tris(2-aminoethyl)amine : B14,
tris[2-(dimethylamino)ethyl]amine : B15,
1,4,7,10-tetraazacyclododecane : B16,
1,4,7,10,13,16-hexaazacycloalkyloctadecane : B17,
N,N,N',N'-tetraethylethylenediamine : B18,
3,6-dimethyl-4-octin-3,6-diol : D2,
2,2'-methylenebis(4-methylphenol) : D3,
2,6-bis[(2-hydroxy-5-methylphenyl)methyl]-4-methylphenol : D4,
1,3-cyclohexanediol : D5,
4,4'-dihydroxybiphenyl : D6,
2,6-naphthalenediol : D7,
2,5-dimethyl-3-hexyne-2,5-diol : D8,
2,5-di-tert-butylhydroquinone : D9,
polyacrylic acid (Mw: about 500) : D10,
polyacrylic acid (Mw: about 1,000) : D11,
polyacrylic acid (Mw: about 10,000) : D12,
copolymer of maleic acid and acrylic acid having a structure shown below (Mw: about 3,000) : D13,

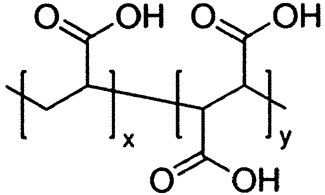

### Preparation Example 2 - 62 of Cleaning Solutions 2-62

Cleaning Solutions 2 - 62 are prepared in the same manner as in Preparation Example 1 except that the polymer (A), the alkaline component (B), the solvent (C), the crack accelerating component (D) and the concentration are changed to those indicated in Tables 1-1 and 1-2. This is indicated in Tables 1-1 and 1-2.

### Comparative Preparation Example 1 of Comparative Cleaning Solution 1

N-benzylethanolamine (TCI, alkaline component (B)) and 2,2-bis(4-hydroxyphenyl)propane (TCI, crack accelerating component (D)) is added to isopropanol (solvent (C)), so that each concentration is 2.5 mass %. The resultant is stirred with a stirrer for 1 hour. This solution is filtered with Optimizer UPE (Nippon Entegris K.K.). Thereby, Comparative Cleaning Solution 1 is obtained. This is indicated in Table 1-2.

### Evaluation of residual amount of particles for Cleaning Solutions 1-62 and Comparative Cleaning Solution 1

Evaluation substrates prepared as described in the above-mentioned preparation of the evaluation substrate are used.

Using Coater/Developer RF³ (SOKUDO Co., Ltd.), 10 cc of each substrate cleaning solution is dripped on each evaluation substrate, and coating and drying are performed by rotating at 1,500 rpm for 60 seconds. While rotating the substrate at 100 rpm, DIW is dripped for 10 seconds, the whole substrate is covered with DIW, and this state is maintained for 20 seconds. By rotating the substrate at 1,500 rpm, the film is dried. When the film exists, the film is peeled off and removed by the rotation.

The amounts of residual particles on these substrates are compared. A bright field defect inspection system (UVision 4, Applied Materials Inc.) is used for the evaluation of the patterned substrate, and a dark field defect inspection system (LS-9110, Hitachi High-Technologies Corporation) is used for the evaluation of the bare substrate.

The state of application and the state of film removal are confirmed, the number of residual particles is counted and evaluated according to the following criteria. The evaluation results are indicated in Table 1.
AA: ≤ 10 pieces
A: > 10 pieces, ≤ 100 pieces
B: > 100 pieces, ≤ 1,000 pieces
C: > 1,000 pieces
D: film is not uniformly applied, or film is not removed

It is confirmed that compared with the substrate cleaned with Comparative Cleaning Solution 1, the substrate cleaned with Cleaning Solutions 1-62 has less amount of residual particles.

### Confirmation of the influence to a copper deposited substrate

A copper deposited substrate is obtained by depositing copper on a 8-inch bare Si substrate using a thermal CVD method (temperature of substrate : 180°C).

Using Coater/Developer RF³ (SOKUDO Co., Ltd.), 10 cc of each substrate cleaning solution is dripped on each evaluation substrate, and coating and drying are performed by rotating at 1,500 rpm for 60 seconds. While rotating the substrate at 100 rpm, DIW is dripped for 10 seconds, the whole substrate is covered with DIW, and this state is maintained for 20 seconds. By rotating the substrate at 1,500 rpm, the film is peeled off and removed to dry the substrate. This substrate is cleaved and the cross section is observed by SEM, to measure the film thickness of the deposited copper. The film thickness of copper after the above process is 100 nm.

### EXPLANATION OF SYMBOLS

1. substrate
2. particle
3. particle holding layer
4. alkaline component
5. remover
6. trace of elution of alkaline component
7. crack
8. crack accelerating component
9. trace of elution of crack accelerating component.

## Claims

1. A method for cleaning a substrate comprising
(1) dripping a substrate cleaning solution on a substrate;
(2) removing a solvent (C) in the substrate cleaning solution, and a polymer (A) forms a film;
(3) making the film to hold particles on the substrate; and
(4) applying a remover (F) on the substrate to remove the film in which the particles are held, wherein
the substrate cleaning solution comprising a polymer (A), an alkaline component (B), and a solvent (C), provided that the alkaline component (B) does not comprise ammonia;
wherein the alkaline component (B) is represented by at least one of the formulae (B-1), (B-2), and (B-3): 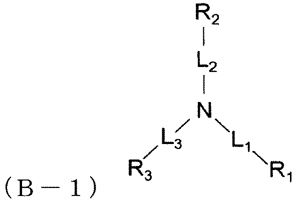
wherein,
L₁ is -CH₂-, -CH₂-CH₂-, -CH₂-CH₂-CH₂-, or the formula (B-1)': 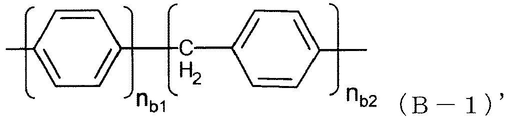
where n_{b1} is 0 or 1, n_{b2} is 0 or 1, and n_{b1} + n_{b2} is not equal to 0,
R₁ is -OH, -NH₂, or -N(CH₃)₂,
L₂ is a single bond, -CH₂-, -CH₂-CH₂-, -CH₂-CH₂-CH₂-, or the above formula (B-1)',
R₂ is -H, -OH, -NH₂, or -N(CH₃)₂,
L₃ is a single bond, -CH₂-, -CH₂-CH₂-, -CH₂-CH₂-CH₂-, or above formula (B-1)', and
R₃ is -H, -OH, -NH₂, or -N(CH₃)₂; 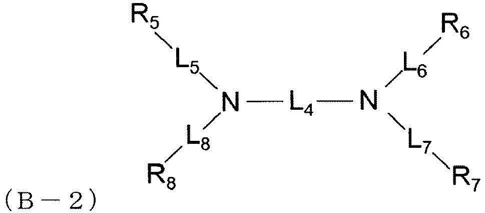
wherein,
L₄ is -CH₂-, -CH₂-CH₂-, or the above formula (B-1)',
L₅, L₆, L₇, and L₈ are each independently -CH₂- or -CH₂-CH₂-,
R₅, R₆, R₇, and R₈ are each independently -OH or -CH₃; and
(B-3) 1,4-diazabicyclo[2.2.2]octane, hexamethylenetetramine or a nitrogen-containing saturated hydrocarbon ring,
comprising -NH-CH₂-CH₂- as a structural unit.

2. The method for cleaning a substrate according to claim 1, wherein the solvent (C) comprises an organic solvent.

3. The method for cleaning a substrate according to claim 1 or 2, wherein the boiling point of the alkaline component (B) at one atmospheric pressure is 20 - 400°C.

4. The method for cleaning a substrate according to one or more of claims 1 to 3, wherein the polymer (A) comprises at least one of novolak, polyhydroxy styrene, polystyrene, polyacrylate derivative, polymaleic acid derivative, polycarbonate, polyvinyl alcohol derivatives, polymethacrylate derivatives, and copolymer of any combination of any of these, and
preferably the polymer (A) does not contain fluorine and/or silicon.

5. The method for cleaning a substrate according to one or more of claims 1 to 4, further comprising a crack accelerating component (D),
wherein preferably the content of the crack accelerating component (D) is 1 - 100 mass % based on the total mass of the polymer (A),
wherein preferably a molecular weight of the crack accelerating component (D) is 80 - 10,000,
wherein preferably the crack accelerating component (D) is not removed with the solvent (C) and remains in the film,
wherein the crack accelerating component (D) comprises hydrocarbon and further comprises a hydroxy group and/or a carbonyl group, wherein
the crack accelerating component (D) is represented by at least one of the formulae (D-1), (D-2), and (D-3):
(D-1) a compound comprising 1 to 6 structural units, wherein the structural unit is represented by the formula (D-1)' and each structural unit is bonded via the linker L₉, 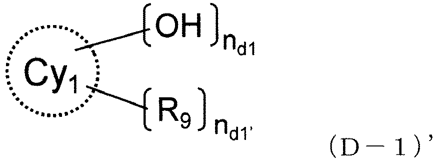
where,
L₉ is selected form at least one of a single bond and a C₁₋₆ alkylene,
Cy₁ is a C₅₋₃₀ hydrocarbon ring,
R₉ is each independently a C₁₋₅ alkyl,
n_{d1} is 1, 2, or 3,
n_{d1'} is 0, 1, 2, 3, or 4; 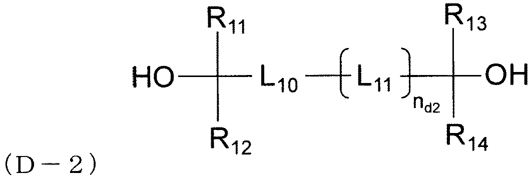
wherein,
R₁₁, R₁₂, R₁₃, and R₁₄ are each independently hydrogen or a C₁₋₅ alkyl,
L₁₀ and L₁₁ are each independently a C₁₋₂₀ alkylene, a C₁₋₂₀ cycloalkylene, a C₂₋₄ alkenylene, a C₂₋₄ alkynylene, or a C₆₋₂₀ arylene, where these groups may be substituted by a C₁₋₅ alkyl or hydroxy,
n_{d2} is 0, 1, or 2; and
(D-3) a polymer comprising a structural unit represented by the formula (D-3)' and having a weight-average molecular weight (M_{w}) of 500 - 10,000, 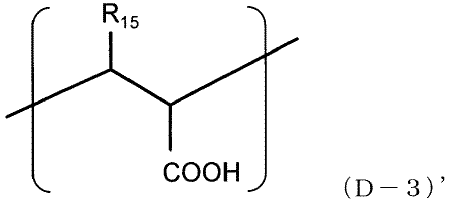
wherein R₁₅ is -H, -CH₃, or -COOH.

6. The method for cleaning a substrate according to one or more of claims 1 to 5, wherein the content of the polymer (A) is 0.1 - 50 mass % based on the total mass of the substrate cleaning solution,
preferably the content of the alkaline component (B) is 1 - 100 mass % based on the total mass of the polymer (A),
preferably the content of the solvent (C) is 0.1 - 99.5 mass % based on the total mass of the substrate cleaning solution.

7. The method for cleaning a substrate according to one or more of claims 1 to 6, wherein the weight-average molecular weight (M_{w}) of the polymer (A) is 150 - 500,000, preferably a molecular weight of the alkaline component (B) is 50 - 500.

8. The method for cleaning a substrate according to one or more of claims 1 to 7, further comprising a further additive (E), wherein the further additive (E) comprises a surfactant, an antibacterial agent, a germicide, an antiseptic, an antifungal agent, or a base, and
preferably the content of the further additive (E) is -up to 10 mass % based on the total mass of the polymer (A).

9. The method for cleaning a substrate according to at least any one of the claims 1 to 8, wherein the substrate cleaning solution is dripped on a substrate and dried to remove the solvent (C), and the polymer (A) forms a film, and
preferably the alkaline component (B)is not removed with the solvent (C) and remains in the film.

10. The method for cleaning a substrate according to one or more of claims 1 to 9, wherein removing the solvent (C) in the substrate cleaning solution in step (2) is carried out by spin-drying.

11. The method for cleaning a substrate according to claim 9, wherein
the remover (F) is neutral or mildly acidic,
preferably the remover (F) comprises pure water and/or preferably the content of the pure water contained in the remover (F) is 80 - 100 mass % based on the total mass of the remover (F).

12. The method for cleaning a substrate according to one or more of claims 1 to 11, wherein a substrate to be cleaned is a non-processed substrate,
preferably the surface of the substrate is a semiconductor, and preferably the surface of the substrate is selected from the group consisting of Si, Ge, SiGe, Si₃N₄, TaN, SiO₂, TiOz, Al₂O₃, SiON, HfO₂, T₂O₅, HfSiO₄, Y₂O₃, GaN, TiN, TaN, Si₃N₄, NbN, Cu, Ta, W, Hf, and Al.

13. The method for cleaning a substrate according to one or more of claims 1 to 11, wherein a substrate to be cleaned is a processed substrate,
preferably the surface of the substrate is a semiconductor, and
preferably the surface of the substrate is selected from the group consisting of Si, Ge, SiGe, Si₃N₄, TaN, SiO₂, TiOz, Al₂O₃, SiON, HfO₂, T₂O₅, HfSiO₄, Y₂O₃, GaN, TiN, TaN, Si₃N₄, NbN, Cu, Ta, W, Hf, and Al.

14. The method for cleaning a substrate according to one or more of claims 1 to 13, further including at least one of the steps of
(0-1) a step of processing the substrate by etching to form a pattern and removing an etching mask;
(0-2) a step of cleaning the substrate;
(0-3) a step of prewetting the substrate;
(0-4) a step of cleaning the substrate;
(3-1) a step of applying a liquid on the particle holding layer;
(5) a step of dripping pure water or an organic solvent on the substrate after the removal of the film in which particles are held and removing pure water or the organic solvent to clean the substrate further; or
(6) a step of drying the substrate.

15. A device manufacturing method, comprising cleaning a substrate by the method according to one or more of claims 1 to 14, and further processing the substrate.

## Patentansprüche

1. Verfahren zum Reinigen eines Substrats, umfassend
(1) Auftropfen einer Substratreinigungslösung auf ein Substrat;
(2) Entfernen eines Lösungsmittels (C) in der Substratreinigungslösung, und ein Polymer (A) bildet einen Film;
(3) Herstellen des Films zum Festhalten von Teilchen auf dem Substrat; und
(4) Aufbringen eines Entferners (F) auf das Substrat, um den Film, in dem die Teilchen gehalten werden, zu entfernen, wobei
die Substratreinigungslösung ein Polymer (A), eine alkalische Komponente (B) und ein Lösungsmittel (C) umfasst, mit der Maßgabe, dass die alkalische Komponente (B) kein Ammoniak enthält;
wobei die alkalische Komponente (B) durch mindestens eine der Formeln (B-1), (B-2) und (B-3) dargestellt wird: 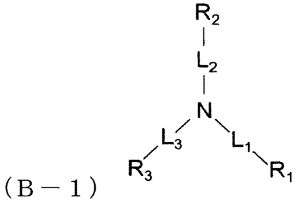 wobei L₁ -CH₂-, -CH₂-CH₂-, -CH₂-CH₂-CH₂-, oder die Formel (B-1)' ist: 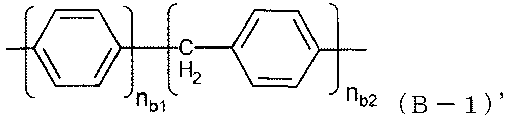 wobei n_{b1} 0 oder 1 ist, n_{b2} 0 oder 1 ist und n_{b1} + n_{b2} nicht gleich 0 ist,
R₁ -OH, -NH₂ oder -N(CH₃)₂ ist,
L₂ eine Einfachbindung, -CH₂-, -CH₂-CH₂-, -CH₂-CH₂-CH₂-, oder die obige Formel (B-1)' ist, R₂ -H, -OH, -NH₂ oder -N(CH₃)₂ ist,
L₃ eine Einfachbindung, -CH₂-, -CH₂-CH₂-, -CH₂-CH₂-CH₂- oder die obige Formel (B-1)' ist, und R₃ -H, -OH, -NH₂ oder -N(CH₃)₂ ist; 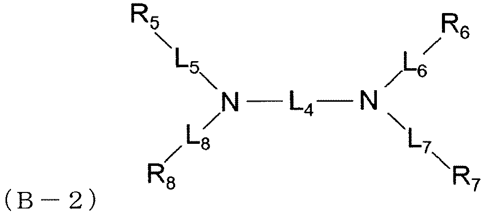 wobei
L₄ -CH₂-, -CH₂-CH₂- oder die obige Formel (B-1)' ist,
L₅, L₆, L₇ und L₈ jeweils unabhängig voneinander -CH₂- oder -CH₂-CH₂- sind,
R₅, R₆, R₇ und R₈ jeweils unabhängig voneinander -OH oder -CH₃ sind; und
(B-3) 1,4-Diazabicyclo[2.2.2]octan, Hexamethylentetramin oder ein stickstoffhaltiger gesättigter Kohlenwasserstoffring ist,
umfassend -NH-CH₂-CH₂- als Struktureinheit.

2. Verfahren zur Reinigung eines Substrats gemäß Anspruch 1, wobei das Lösungsmittel (C) ein organisches Lösungsmittel umfasst.

3. Verfahren zur Reinigung eines Substrats gemäß Anspruch 1 oder 2, wobei der Siedepunkt der alkalischen Komponente (B) bei einem Atmosphärendruck 20 - 400°C beträgt.

4. Verfahren zum Reinigen eines Substrats nach einem oder mehreren der Ansprüche 1 bis 3, wobei das Polymer (A) mindestens eines von Novolak, Polyhydroxystyrol, Polystyrol, Polyacrylat-Derivat, Polymaleinsäure-Derivat, Polycarbonat, Polyvinylalkohol-Derivate, Polymethacrylat-Derivate und Copolymer einer beliebigen Kombination davon umfasst, und
vorzugsweise das Polymer (A) kein Fluor und/oder Silizium enthält.

5. Verfahren zur Reinigung eines Substrats gemäß einem oder mehreren der Ansprüche 1 bis 4, ferner umfassend eine rissbeschleunigende Komponente (D),
wobei vorzugsweise der Gehalt an der rissbeschleunigenden Komponente (D) 1 - 100 Massen-%, bezogen auf die Gesamtmasse des Polymers (A), beträgt,
wobei vorzugsweise das Molekulargewicht der rissbeschleunigenden Komponente (D) 80 - 10.000 beträgt,
wobei vorzugsweise die rissbeschleunigende Komponente (D) nicht mit dem Lösungsmittel (C) entfernt wird und in dem Film verbleibt,
wobei die rissbeschleunigende Komponente (D) Kohlenwasserstoff umfasst und ferner eine Hydroxygruppe und/oder eine Carbonylgruppe umfasst, wobei
die rissbeschleunigende Komponente (D) durch mindestens eine der Formeln (D-1), (D-2) und (D-3) dargestellt wird:
(D-1) eine Verbindung, umfassend 1 bis 6 Struktureinheiten, wobei die Struktureinheit durch die Formel (D-1)' dargestellt wird und jede Struktureinheit über den Linker L₉ gebunden ist, 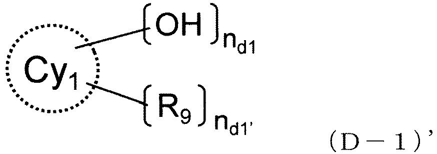 wobei L₉ ausgewählt ist aus mindestens einem von einer Einfachbindung und einem C₁₋₆-Alkylen,
Cy₁ ein C₅₋₃₀-Kohlenwasserstoffring ist,
R₉ jeweils unabhängig ein C₁₋₅-Alkyl ist,
n_{d1} 1, 2 oder 3 ist,
n_{d1'} 0, 1, 2, 3 oder 4 ist; 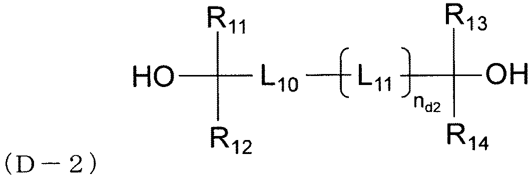 wobei
R₁₁, R₁₂, R₁₃ und R₁₄ jeweils unabhängig voneinander Wasserstoff oder ein C₁₋₅-Alkyl sind,
L₁₀ und L₁₁ jeweils unabhängig ein C₁₋₂₀-Alkylen, ein C₁₋₂₀-Cycloalkylen, ein C₂₋₄-Alkenylen, ein C₂₋₄-Alkinylen oder ein C₆₋₂₀-Arylen sind, wobei diese Gruppen durch ein C₁₋₅-Alkyl oder Hydroxy substituiert sein können,
n_{d2} 0, 1 oder 2 ist; und
(D-3) ein Polymer ist, das eine durch die Formel (D-3)' dargestellte Struktureinheit umfasst und ein gewichtsmittleres Molekulargewicht (Mw) von 500 - 10.000 aufweist, 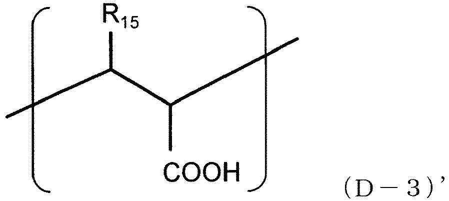 wobei R₁₅ -H, -CH₃ oder -COOH ist.

6. Verfahren zur Reinigung eines Substrats gemäß einem oder mehreren der Ansprüche 1 bis 5,
wobei der Gehalt des Polymers (A) 0,1 - 50 Massen-%, bezogen auf die Gesamtmasse der Substratreinigungslösung, beträgt,
vorzugsweise der Gehalt an der alkalischen Komponente (B) 1 - 100 Massen-%, bezogen auf die Gesamtmasse des Polymers (A), beträgt,
vorzugsweise der Gehalt des Lösungsmittels (C) 0,1 - 99,5 Massen-%, bezogen auf die Gesamtmasse der Substratreinigungslösung beträgt.

7. Verfahren zum Reinigen eines Substrats gemäß einem oder mehreren der Ansprüche 1 bis 6, wobei das gewichtsmittlere Molekulargewicht (Mw) des Polymers (A) 150 - 500.000 beträgt, vorzugsweise beträgt das Molekulargewicht der alkalischen Komponente (B) 50 - 500.

8. Verfahren zum Reinigen eines Substrats gemäß einem oder mehreren der Ansprüche 1 bis 7, das ferner ein weiteres Additiv (E) umfasst,
wobei das weitere Additiv (E) ein Tensid, ein antibakterielles Mittel, ein Germizid, ein Antiseptikum, ein Antimykotikum oder eine Base umfasst, und
vorzugsweise beträgt der Gehalt des weiteren Additivs (E) bis zu 10 Masse-%, bezogen auf die Gesamtmasse des Polymers (A).

9. Verfahren zur Reinigung eines Substrats gemäß mindestens einem der Ansprüche 1 bis 8,
wobei die Substratreinigungslösung auf ein Substrat getropft und getrocknet wird, um das Lösungsmittel (C) zu entfernen, und das Polymer (A) einen Film bildet, und
vorzugsweise die alkalische Komponente (B) nicht mit dem Lösungsmittel (C) entfernt wird und in dem Film verbleibt.

10. Verfahren zur Reinigung eines Substrats gemäß einem oder mehreren der Ansprüche 1 bis 9, wobei die Entfernung des Lösungsmittels (C) in der Substratreinigungslösung in Schritt (2) durch Schleudertrocknung durchgeführt wird.

11. Verfahren zur Reinigung eines Substrats gemäß Anspruch 9, wobei
der Entferner (F) neutral oder leicht sauer ist,
vorzugsweise der Entferner (F) reines Wasser umfasst und/oder
vorzugsweise der Anteil des im Entferner (F) enthaltenen reinen Wassers 80 - 100 Massen-% bezogen auf die Gesamtmasse des Entferners (F) beträgt.

12. Verfahren zur Reinigung eines Substrats gemäß einem oder mehreren der Ansprüche 1 bis 11, wobei ein zu reinigendes Substrat ein unbearbeitetes Substrat ist,
vorzugsweise die Oberfläche des Substrats ein Halbleiter ist, und
vorzugsweise die Oberfläche des Substrats ausgewählt ist aus der Gruppe bestehend aus Si, Ge, SiGe, Si₃N₄, TaN, SiO₂, TiO₂, Al₂O₃, SiON, HfO₂, T₂O₅, HfSiO₄, Y₂O₃, GaN, TiN, TaN, Si₃N₄, NbN, Cu, Ta, W, Hf, und Al.

13. Verfahren zur Reinigung eines Substrats gemäß einem oder mehreren der Ansprüche 1 bis 11, wobei ein zu reinigendes Substrat ein bearbeitetes Substrat ist,
vorzugsweise die Oberfläche des Substrats ein Halbleiter ist, und
vorzugsweise die Oberfläche des Substrats ausgewählt ist aus der Gruppe bestehend aus Si, Ge, SiGe, Si₃N₄, TaN, SiO₂, TiO₂, Al₂O₃, SiON, HfO₂, T₂O₅, HfSiO₄, Y₂O₃, GaN, TiN, TaN, Si₃N₄, NbN, Cu, Ta, W, Hf, und Al.

14. Verfahren zur Reinigung eines Substrats gemäß einem oder mehreren der Ansprüche 1 bis 13, das ferner mindestens einen der folgenden Schritte umfasst
(0-1) einen Schritt der Bearbeitung des Substrats durch Ätzen zur Bildung eines Musters und Entfernen einer Ätzmaske;
(0-2) einen Schritt des Reinigens des Substrats;
(0-3) einen Schritt des Vorbenetzens des Substrats;
(0-4) einen Schritt des Reinigens des Substrats;
(3-1) einen Schritt des Auftragens einer Flüssigkeit auf die Teilchenhaltende schicht;
(5) einen Schritt des Auftropfens von reinem Wasser oder eines organischen Lösungsmittels auf das Substrat nach dem Entfernen des Films, in dem die Teilchen gehalten werden, und des Entfernens von reinem Wasser oder des organischen Lösungsmittels zur weiteren Reinigung des Substrats; oder
(6) einen Schritt des Trocknens des Substrats.

15. Verfahren zur Herstellung einer Vorrichtung, umfassend das Reinigen eines Substrats durch das Verfahren gemäß einem oder mehreren der Ansprüche 1 bis 14 und die weitere Verarbeitung des Substrats.

## Revendications

1. Procédé pour le nettoyage d'un substrat comprenant
(1) ruissellement d'une solution de nettoyage de substrat sur un substrat ;
(2) élimination d'un solvant (C) dans la solution de nettoyage de substrat, et un polymère (A) formant un film ;
(3) faire en sorte que le film maintienne des particules sur le substrat ; et
(4) application d'un agent d'élimination (F) sur le substrat pour éliminer le film dans lequel les particules sont maintenues,
la solution de nettoyage de substrat comprenant un polymère (A), un composant alcalin (B), et un solvant (C),
à condition que le composant alcalin (B) ne comprenne pas d'ammoniac ;
le composant alcalin (B) étant représenté par au moins l'une des formules (B-1), (B-2), et (B-3) : 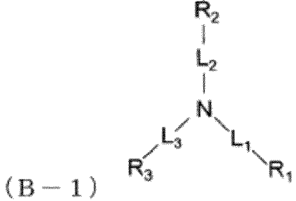
L₁ étant -CH₂-, -CH₂-CH₂-, -CH₂-CH₂-CH₂-, ou la formule (B-1)' : 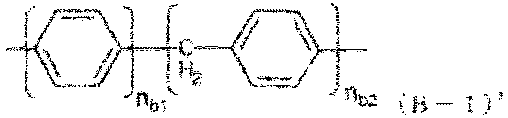
n_{b1} étant 0 ou 1, n_{b2} étant 0 ou 1, et n_{b1} + n_{b2} n'étant pas égal à 0,
R₁ étant -OH, -NH₂, ou -N(CH₃)₂,
L₂ étant une simple liaison, -CH₂-, -CH₂-CH₂-, -CH₂-CH₂-CH₂-, ou la formule ci-dessus (B-1) ' ,
R₂ étant -H, -OH, -NH₂, ou -N(CH₃)₂,
L₃ étant une simple liaison, -CH₂-, -CH₂-CH₂-, -CH₂-CH₂-CH₂-, ou la formule ci-dessus (B-1) ' , et
R₃ étant -H, -OH, -NH₂, ou -N(CH₃)₂ ; 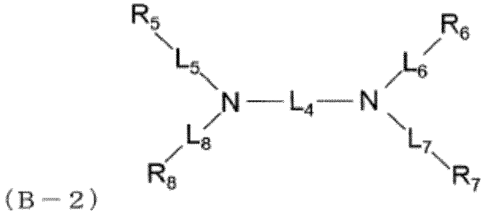
L₄ étant -CH₂-, -CH₂-CH₂-, ou la formule ci-dessus (B-1)',
L₅, L₆, L₇, et L₈ étant chacun indépendamment -CH₂-ou -CH₂-CH₂-,
R₅, R₆, R₇, et R₈ étant chacun indépendamment -OH ou -CH₃ ; et
(B-3) 1,4-diazabicyclo[2.2.2]octane, hexaméthylènetétramine ou un cycle hydrocarboné saturé contenant de l'azote,
comprenant -NH-CH2-CH2- en tant qu'un motif structural.

2. Procédé pour le nettoyage d'un substrat selon la revendication 1, le solvant (C) comprenant un solvant organique.

3. Procédé pour le nettoyage d'un substrat selon la revendication 1 ou 2, le point d'ébullition du composant alcalin (B) à une pression atmosphérique étant de 20 à 400 °C.

4. Procédé pour le nettoyage d'un substrat selon une ou plusieurs des revendications 1 à 3, le polymère (A) comprenant au moins l'un parmi une novolaque, un polyhydroxystyrène, un polystyrène, un dérivé de polyacrylate, un dérivé de poly(acide maléique), un polycarbonate, des dérivés de poly(alcool vinylique), des dérivés de polyméthacrylate, et un copolymère d'une quelconque combinaison de n'importe lesquels de ceux-ci, et
préférablement le polymère (A) ne contenant pas de fluor et/ou de silicium.

5. Procédé pour le nettoyage d'un substrat selon une ou plusieurs des revendications 1 à 4, comprenant en outre un composant d'accélération de fissures (D),
préférablement la teneur du composant d'accélération de fissures (D) étant de 1 à 100 % en masse sur la base de la masse totale du polymère (A),
préférablement un poids moléculaire du composant d'accélération de fissures (D) étant de 80 à 10 000, préférablement le composant d'accélération de fissures (D) n'étant pas éliminé avec le solvant (C) et restant dans le film,
le composant d'accélération de fissures (D) comprenant un hydrocarbure et comprenant en outre un groupe hydroxy et/ou un groupe carbonyle,
le composant d'accélération de fissures (D) étant représenté par au moins l'une des formules (D-1), (D-2), et (D-3) :
(D-1) un composé comprenant 1 à 6 motifs structuraux, le motif structural étant représenté par la formule (D-1)' et chaque motif structural étant lié via le lieur L₉, 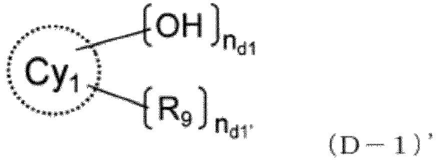
où,
L₉ est choisi parmi au moins l'un parmi une simple liaison et un C₁₋₆ alkylène,
Cy₁ est un cycle hydrocarboné en C₅₋₃₀,
R₉ est chacun indépendamment un C₁₋₅ alkyle,
n_{d1} est 1, 2, ou 3,
n_{d1'} est 0, 1, 2, 3, ou 4 ; 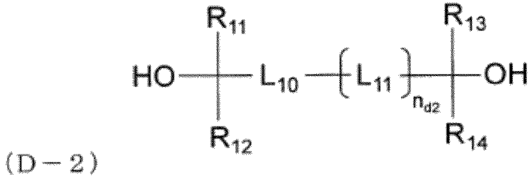
R₁₁, R₁₂, R₁₃, et R₁₄ étant chacun indépendamment hydrogène ou un C₁₋₅ alkyle,
L₁₀ et L₁₁ étant chacun indépendamment un C₁₋₂₀ alkylène, un C₁₋₂₀ cycloalkylène, un C₂₋₄ alcénylène, un C₂₋₄ alcynylène, ou un C₆₋₂₀ arylène, où ces groupes peuvent être substitués par un C₁₋₅ alkyle ou hydroxy,
n_{d2} étant 0, 1, ou 2 ; et
(D-3) un polymère comprenant un motif structural représenté par la formule (D-3)' et ayant un poids moléculaire moyen en poids (M_{w}) de 500 à 10 000, 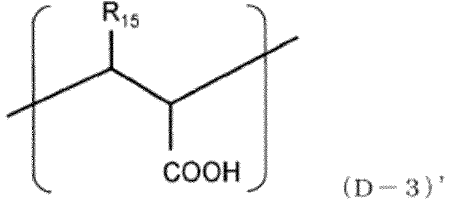
R₁₅ étant -H, -CH₃, ou -COOH.

6. Procédé pour le nettoyage d'un substrat selon une ou plusieurs des revendications 1 à 5, la teneur du polymère (A) étant de 0,1 à 50 % en masse sur la base de la masse totale de la solution de nettoyage de substrat,
préférablement la teneur du composant alcalin (B) étant de 1 à 100 % en masse sur la base de la masse totale du polymère (A),
préférablement la teneur du solvant (C) étant de 0,1 à 99,5 % en masse sur la base de masse totale de la solution de nettoyage de substrat.

7. Procédé pour le nettoyage d'un substrat selon une ou plusieurs des revendications 1 à 6, le poids moléculaire moyen en poids (M_{w}) du polymère (A) étant de 150 à 500 000, préférablement un poids moléculaire du composant alcalin (B) étant de 50 à 500.

8. Procédé pour le nettoyage d'un substrat selon une ou plusieurs des revendications 1 à 7, comprenant en outre un additif supplémentaire (E), l'additif supplémentaire (E) comprenant un tensioactif, un agent antibactérien, un germicide, un antiseptique, un agent antifongique ou une base, et
préférablement la teneur de l'additif supplémentaire (E) étant jusqu'à 10 % en masse sur la base de la masse totale du polymère (A).

9. Procédé pour le nettoyage d'un substrat selon au moins l'une quelconque des revendications 1 à 8, la solution de nettoyage de substrat étant ruisselée sur un substrat et séchée pour éliminer le solvant (C), et le polymère (A) formant un film, et
préférablement le composant alcalin (B) n'étant pas éliminé avec le solvant (C) et restant dans le film.

10. Procédé pour le nettoyage d'un substrat selon une ou plusieurs des revendications 1 à 9, l'élimination du solvant (C) dans la solution de nettoyage de substrat dans l'étape (2) étant réalisée par séchage par centrifugation.

11. Procédé pour le nettoyage d'un substrat selon la revendication 9,
l'agent d'élimination (F) étant neutre ou légèrement acide,
préférablement l'agent d'élimination (F) comprenant de l'eau pure et/ou
préférablement la teneur de l'eau pure contenue dans l'agent d'élimination (F) étant de 80 à 100 % en masse sur la base de la masse totale de l'agent d'élimination (F).

12. Procédé pour le nettoyage d'un substrat selon une ou plusieurs des revendications 1 à 11, un substrat devant être nettoyé étant un substrat non traité,
préférablement la surface du substrat étant un semiconducteur, et
préférablement la surface du substrat étant choisie dans le groupe constitué par Si, Ge, SiGe, Si₃N₄, TaN, SiO₂, TiO₂, Al₂O₃, SiON, HfO₂, T₂O₅, HfSiO₄, Y₂O₃, GaN, TiN, TaN, Si₃N₄, NbN, Cu, Ta, W, Hf, et Al.

13. Procédé pour le nettoyage d'un substrat selon une ou plusieurs des revendications 1 à 11, un substrat devant être nettoyé étant un substrat traité,
préférablement la surface du substrat étant un semiconducteur, et
préférablement la surface du substrat étant choisie dans le groupe constitué par Si, Ge, SiGe, Si₃N₄, TaN, SiO₂, TiO₂, Al₂O₃, SiON, HfO₂, T₂O₅, HfSiO₄, Y₂O₃, GaN, TiN, TaN, Si₃N₄, NbN, Cu, Ta, W, Hf, et Al.

14. Procédé pour le nettoyage d'un substrat selon une ou plusieurs des revendications 1 à 13, comprenant en outre au moins l'une des étapes parmi
(0-1)une étape de traitement du substrat par gravure pour former un motif et élimination d'un masque de gravure ;
(0-2)une étape de nettoyage du substrat ;
(0-3)une étape de prémouillage du substrat ;
(0-4)une étape de nettoyage du substrat ;
(3-1)une étape d'application d'un liquide sur la couche de maintien de particules ;
(5) une étape de ruissellement d'eau pure ou d'un solvant organique sur le substrat après l'élimination du film dans lequel des particules sont maintenues et élimination d'eau pure ou du solvant organique pour nettoyer le substrat davantage ; ou
(6) une étape de séchage du substrat.

15. Procédé de fabrication de dispositif, comprenant le nettoyage d'un substrat par le procédé selon une ou plusieurs des revendications 1 à 14, et en outre le traitement du substrat.
